# EUROPEAN PATENT APPLICATION

(11) **EP 4 340 021 A1**
(43) Date of publication of application: **20.03.2024**
(21) Application number: 22196178.2
(22) Date of filing: 16.09.2022
(51) Int. Cl.: H01L 23/495

(54) **REDUCED STRESS CLIP FOR SEMICONDUCTOR DIE**

(71) Applicant: Nexperia B.V., 6534 AB Nijmegen (NL)
(72) Inventor: Malveda, Homer, Cabuyao (PH); Dimaano, Antonio, Cabuyao (PH); Nunag, George, Cabuyao (PH)
(74) Representative: Pjanovic, Ilija

(57) **Abstract**

A lead frame for connecting a semiconductor die to a base plate, the lead frame comprising:
one or more lead portions, configured for connecting the lead frame to the base plate;
a first contact element configured to be connected to a source of the semiconductor die; and
a second contact element configured to be connected to a drain of the semiconductor die,
wherein the second contact element comprises at least two contact portions that in an assembled state of the lead frame each contact the drain of the semiconductor die with a contact area thereof, the contact areas of the respective contact portions being spaced apart from each other.

## Description

### Technical field

The present disclosure relates to a lead frame, or clip, for connecting a semiconductor die to a base plate, as well as a semiconductor package comprising such a lead frame.

### Background

To connect a semiconductor die to a base plate, such as a printed circuit board, lead frames can be used. The connection comprises a mechanical and an electrical connection. Lead frames as such are known, and are an evolution of prior wire bond connections.

At one end of the lead frame, it may comprise one or more contact elements with which the lead frame is connected to the semiconductor die. This connection is typically made with solder material. At the other end of the lead frame, it may comprise one or more lead portions, with which the lead frame is connected to a printed circuit board. Whereas the semiconductor is made of a semiconductor material, e.g. silicon, germanium or gallium arsenide, the lead frame can be made of copper.

### Summary

Copper and semiconductor materials have different thermal expansion coefficients, which may lead to the connection between the lead frame and the semiconductor die being stressed when the lead frame heats. This heating of the lead frame may e.g. result from a high voltage being applied on the lead frame and/or switching at a high frequency. For the most demanding applications, voltages are high (650V or more) and switching frequencies are high as well. At such applications, the stress due to different thermal expansion coefficients of the copper material and the semiconductor material incur cracks in the semiconductor material, with ultimately a failure of the semiconductor die.

The present disclosure aims to eliminate the stress between the contact elements of the lead frame on the one hand and the semiconductor die on the other hand, in particular when the semiconductor package is operated at high voltages and/or at high frequencies.

A summary of aspects of certain examples disclosed herein is set forth below. It should be understood that these aspects are presented merely to provide the reader with a brief summary of these certain embodiments, and that these aspects are not intended to limit the scope of this disclosure. Indeed, this disclosure may encompass a variety of aspects and/or a combination of aspects that may not be set forth.

In a first aspect of the present disclosure, there is presented a lead frame for connecting a semiconductor die to a base plate, the lead frame comprising one or more lead portions, configured for connecting the lead frame to the base plate; a first contact element configured to be connected to a source of the semiconductor die; and a second contact element configured to be connected to a drain of the semiconductor die, wherein the second contact element comprises at least two contact portions that in an assembled state of the lead frame each contact the drain of the semiconductor die with a contact area thereof, the contact areas of the respective contact portions being spaced apart from each other.

A lead frame is also known in the art as a "clip" with which the semiconductor die may be attached to a printed circuit board. Frames are often made of copper as copper has excellent electrical propagation characteristics, but this is not required per se. The lead frame comprises one or more lead portion, also known as "leads", that typically protrude from a semiconductor package and with which the lead frame is connected to the base plate. Via the leads signals can be passed to the base plate.

The lead frame also comprises two contact elements, connected to the source and the drain of the die and, when the die also comprises a gate, there may be a third contact element connected to said gate. As described in the above, especially at the drain of the semiconductor die the different thermal expansion coefficients of the lead frame material compared to the semiconductor material may cause stress in the semiconductor die.

The present disclosure propose to embody the contact element that in an assembled state is connected to the drain of the semiconductor die as a contact element featuring two distinct contact portions, that are spaced apart from each other and that each have a contact portion with which they contact the drain of the semiconductor die. Due to this spacing apart of the contact portion, when the lead frame material expands it cannot only expand in the vertical direction (as in the prior art), but it may also expand in the sidewards direction. As such, the stress invoked due to the - additional - thermal expansion of the lead frame material compared to the thermal expansion of the semiconductor material when the materials heat can be spread over a larger surface area and the peak of this stress is lower. In certain embodiments a stress reduction of over 50% has been achieved by the inventors.

According to an embodiment of the disclosure the lead frame is made as a single component. For example, the lead frame may be folded over the semiconductor die in the assembled state of the lead frame, so that the lead frame is entirely external of the semiconductor die, without parts of the lead frame being interconnected to each other.

According to an embodiment of the disclosure the connection between the second contact element and the semiconductor die is formed by a soldered connection between the contact areas of each of the contact portions and the drain of the semiconductor die. Soldering is a well-known way to connect a lead frame to a die. To guarantee an optima connection, preferably each of the separate connection portions is welded to the drain of the semiconductor die.

In embodiments, at least one of the contact portions of the second contact element comprises an outgassing hole. In particular, an outgassing hole may be present when the connection between the contact portion and the drain of the semiconductor die is formed by a soldered connection and when the contact portion is relatively wide, say 0.4mm or wider. An outgassing hole is a proven technique which allows gasses formed during the curing of the solder material to escape from the connection area, resulting in a more durable connection.

In alternative embodiments the contact portions of the second contact element are narrow enough to allow such gasses to escape via the side of the contact portion, so that no outgassing hole is needed and so that the contact portion is substantially solid when seen from above. In particular, this may be the case when a width of the respective contact portion is less than 0.4mm

In embodiments, all contact portions have the same width. This is however not required, it is very well possible that one of the at least two contact portions is wider than another one of the at least two contact portions.

According to an embodiment of the disclosure the at least two contact portions of the second contact element are arranged parallel to each other, a slit being defined in between two neighbouring contact portions. When seen on a microscale the width of the slit may vary over time, the slit reducing in width as the contact portions of the lead frame heat and expand sidewards. A parallel orientation of the contact portions allows the contact portion to expand with the same amount over its entire length so that, when the slit has a sufficient width, the expansion in the sidewards direction can be unhindered, unrestricted and universally.

For example, a width of the slit is smaller than a width of the contact portion. In particular, a ratio between the width of the slit and the width of the contact portion may be between 0.1 and 0.3.

According to an embodiment of the disclosure the contact portions of the second contact element are mutually interconnected by an overhang, the overhang in an assembled state of the lead frame being free from the drain. The overhang in particular ensures that the relatively thin and weak contact portions do not bend, so that the contact portions and the drain neatly align and contact between the drain and the contact portions can be ensured without stressing on of the two components.

According to an embodiment of the disclosure the lead frame is made of a material that comprises copper and preferably is made entirely of copper. Copper is a material that has excellent electrical propagation properties while being relatively cheap.

According to an embodiment of the disclosure the first and second contact element are mutually spaced apart in an assembled state of the lead frame. That is to say, to prevent a shorting of the lead frame preferably no electron transfer is possible directly from the first contact element connected to the source of the semiconductor die and the second contact element connected to the gain of the semiconductor die. When a third contact element, connected to a gate of the semiconductor die, is present, preferably also said third contact element is spaced apart from the first and second contact element.

According to an embodiment of the disclosure the second contact element comprises a discrete number of individual contact portions, in particular in between 2 and 10 contact portions. The exact number of contact portions may vary depending on e.g. cooling requirements and allowed mechanical stress at the interface of the semiconductor die and the lead frame.

The advantages that are achieved at the drain of the semiconductor die, by forming the second contact element with at least two contact portions, may also be achieved at the source of the semiconductor die, by forming the first contact element with at least two contact portions. In such an embodiment the first contact element of the lead frame comprises at least two contact portions that in an assembled state of the lead frame each contact the source of the semiconductor die with a contact area thereof, the contact areas of the respective contact portions being spaced apart from each other.

It goes without saying that any embodiments that have been described as advantageous for the contact portions of the second contact element may also be implemented on the contact portions of the first contact element - to result in the same or similar technical advantages.

According to a second aspect the present disclosure relates to a semiconductor package comprising a semiconductor die and the lead frame as described in the above, the lead frame being connected to the semiconductor die.

In particular, the semiconductor die is a metal-oxide-semiconductor field-effect transistor (MOSFET).

It is noted that the definitions and advantages associated with the first aspect of the present disclosure being a lead frame are also associated equally with the second aspect of the present disclosure being a semiconductor package.

### Brief description of the drawings

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. If only the first reference label is used in the specification, the description is applicable to any one of the similar components having the same first reference label irrespective of the second reference label.

The above and other aspects of the disclosure will be apparent from and elucidated with reference to the examples described hereinafter.
Fig. 1 illustrates a first exemplary embodiment of a lead frame according to the present disclosure;
Fig. 2 illustrates a detailed view of one of the contact elements of the lead frame as shown in Fig. 1; and
Fig. 3 illustrates an exemplary embodiment of a semiconductor package comprising a second exemplary embodiment of a lead frame.

### Detailed description

It is noted that in the description of the figures, same reference numerals refer to the same or similar components performing a same or essentially similar function.

A more detailed description is made with reference to particular examples, some of which are illustrated in the appended drawings, such that the manner in which the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used therein, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all of the following interpretations of the word: any of the items in the list, all of the items in the list, and any combination of the items in the list.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

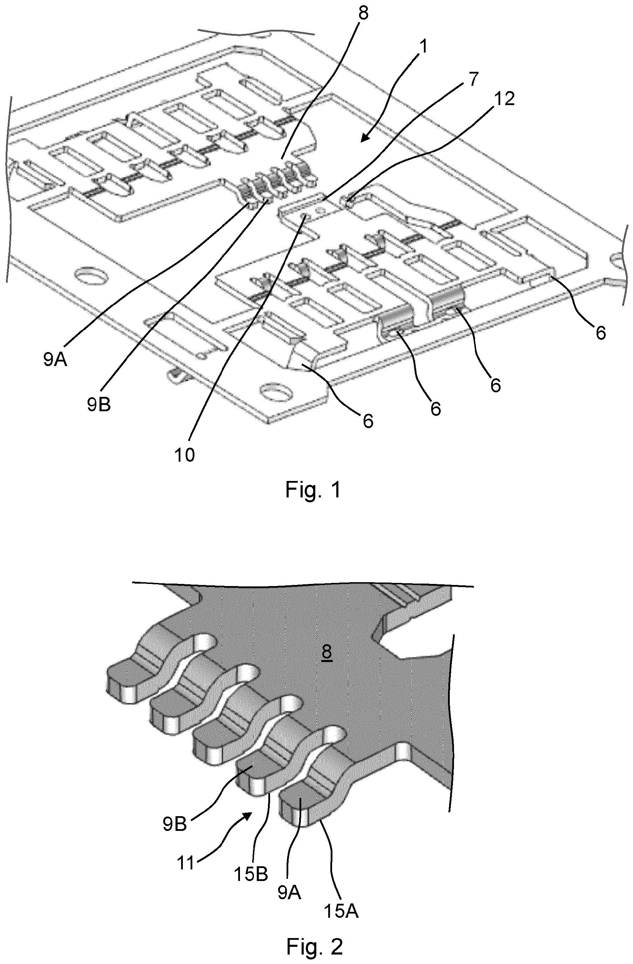

Turning now to Fig. 1, shown here is a lead frame 1 in isolation of any semiconductor dies and any base plates and as a stand-alone part. As such, the lead frame 1 may be received from a lead frame manufacturer by a lead frame processor in the shape as shown in Fig. 1. The lead frame comprises a number of lead portions 6, with which the lead frame 1 may be connected to a printed circuit board (that is not shown in Fig. 1). Although not required, a typical material for lead frames 1 is copper.

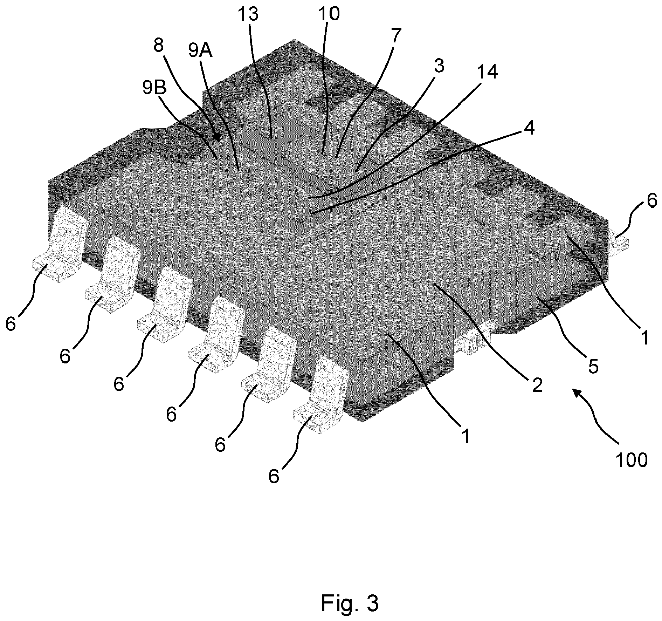

As shown here, the lead frame 1 includes a first contact element 7, that in an assembled state of the lead frame 1 is connected to a source of a semiconductor die, a second contact element 8, that in an assembled state of the lead frame 1 is connected to a drain of a semiconductor die as well as a third contact element 12, that in an assembled state of the lead frame 1 is connected to a gate of a semiconductor die. Note how the first 7, second 8 and third 12 contact elements are mutually spaced apart and do not contact each other, so that the flow of electrons from one of the contact elements 7, 8, 12 to another one of the contact elements 7, 8, 12 is not possible. This will be the case for the lead frame 1 in a non-assembled state as shown in Fig. 1, but in particular also for the lead frame 1 in the assembled state, as shown in Fig. 3.

With particular reference to Fig. 2, wherein the second contact element 8 is shown in more detail, it can be seen that the second contact element 8 comprises at least two, here five, contact portions 9A, 9B. In an assembled state of the lead frame, each of these contact portions 9A, 9B contacts the drain of the semiconductor with a contact area 15A, 15B of the contact portions 9A, 9B. The contact areas 15A, 15B of the respective contact portions 9A, 9B are spaced apart, with a slit 11 being defined in between the contact areas 15A, 15B. This slit 11 ensures that the material of the contact element 8, at the location where it is connected to the drain of the semiconductor die, can expand in the sidewards direction when the material expands due to it being heated. In particular, a width of the slit 11 will typically be smaller than a width of a contact portion 9A, 9B. Preferably a ratio between the width of the slit 11 and the width of the contact portion 9A, 9B will be in between 0.1 and 0.3.

In particular, the second contact element 8 includes a discrete number of individual contact portions 9A, 9B wherein two neighbouring contact portions 9A, 9B are separated by slits 11. The second contact element 8 includes at least two discrete contact portions 9A, 9B, but may e.g. contain up to 10 discrete contact portions 9a, 9B, with the present figure showing five of them. Each of the contact portions 9A, 9B here has a same width, but that is not required per se.

Generally speaking, when there are less contact portions 9A, 9B, they may each be wider than when there are more contact portions 9A, 9B. For example, when there only two or three contact portions 9A, 9B each portion 9A, 9B may be wider than 0.4 mm and they may include an outgassing hole to allow optimal bonding of the contact portion 9A, 9B to the drain of the semiconductor die. Although not shown for this embodiment, such an outgassing hole 10 is e.g. shown at the first contact element 7 in Figures 1 and 3. For example, in the present embodiment there are five contact portions 9A, 9B that e.g. each may have a width of less than 0.4 mm. In such cases, implementing an outgassing hole may be foregone as the gasses rising during the curing of solder material may escape below the connection surface via the side of the contact portion 9A, 9B.

In particular it may be noted how each of the contact portions 9A, 9B is substantially straight (when seen from above) and how each of the contact portions 9A, 9B are arranged parallel to each other. This ensures that the contact portions 9A, 9B may expand universally when heated, causing the least amount of internal stress.

Turning now to Fig. 3, shown here is a semiconductor package 100 comprising a semiconductor die 2 and a lead frame 1 such as the lead frame 1 described in relation to figures 1 and 2 - although the lead frame 1 shown in figure 3 differs in some details compared to the lead frame 1 that was previously discussed. In particular, the semiconductor die 2 may be a metal-oxide-semiconductor field-effect transistor (MOSFET).

Such a semiconductor die 2 may comprise a gate 13, a source 3 and a drain 4. Connected to the source 3, the drain 4 and the gate 13 are a first contact element 7, a second contact element 8 and a third contact element 12 respectively. The connection between the contact elements 7, 8, 12 and the semiconductor die 2 may e.g. be achieved with solder material that is cured after its application.

Although in the shown embodiments the first contact element 7, the second contact element 8 and the third contact element 12 are all integrally formed with the lead frame 1, it would be well possible to establish the electrical connection between the gate 13 and the lead frame 1 and/or the source 3 and the lead frame 1 via one or more wire bonds without departing from the inventive concept as disclosed herein.

An important distinction between the lead frame 1 shown in figure 3 and the lead frame 1 shown in figures 1 and 2 is that the contact portions 9A, 9B of the lead frame 1 shown in figure 3 are connected with a overhang 14 at their outer ends. The overhang 14 does not contact the drain 4 of the semiconductor die 2 and protect the contact portions 9A, 9B against bending during handling of the lead frame 1. Besides the above-mentioned functions, the overhang 14 essentially bridges the individual contact portions 9A, 9B and may therefore alternatively be referred to as a "bridge".

### LIST OF REFERENCE NUMERALS

- 1: Lead frame
- 2: Semiconductor die
- 3: Source
- 4: Drain
- 5: Base plate
- 6: Lead portion
- 7: First contact element
- 8: Second contact element
- 9: Contact portion
- 10: Outgassing hole
- 11: Slit
- 12: Third contact element
- 13: Gate
- 14: Overhang
- 15: Contact area
- 100: Semiconductor package

## Claims

1. A lead frame (1) for connecting a semiconductor die (2) to a base plate (5), the lead frame (1) comprising:
one or more lead portions (6), configured for connecting the lead frame (1) to the base plate (5);
a first contact element (7) configured to be connected to a source (3) of the semiconductor die (2); and
a second contact element (8) configured to be connected to a drain (4) of the semiconductor die (2),
wherein the second contact element (8) comprises at least two contact portions (9A, 9B) that in an assembled state of the lead frame (1) each contact the drain (4) of the semiconductor die (2) with a contact area (15A, 15B) thereof, the contact areas (15A, 15B) of the respective contact portions (9A, 9B) being spaced apart from each other.

2. The lead frame (1) according to claim 1, wherein the lead frame (1) is made as a single component.

3. The lead frame (1) according to any one of the preceding claims, wherein the connection between the second contact element (8) and the semiconductor die (2) is formed by a soldered connection between the contact areas (15A, 15B) of each of the contact portions (9A, 9B) and the drain (4) of the semiconductor die (2).

4. The lead frame (1) according to any one of the preceding claims, wherein at least one of the contact portions (9A, 9B) of the second contact element (8) comprises an outgassing hole (10).

5. The lead frame (1) according to any one of the claims 1 - 4, wherein a width of at least one of the contact portions (9A, 9B) of the second contact element (8) is smaller than 0.4 mm.

6. The lead frame (1) according to any one of the preceding claims, wherein the at least two contact portions (9A, 9B) of the second contact element (8) are arranged parallel to each other, a slit being defined in between two neighbouring contact portions (9A, 9B).

7. The lead frame (1) according to claim 6, wherein a width of the slit (11) is smaller than a width of the contact portion (9A, 9B), preferably wherein a ratio between the width of the slit (110 and the width of the contact portion (9A, 9B) is between 0.1 and 0.3.

8. The lead frame (1) according to any one of the preceding claims, wherein the contact portions (9A, 9B) of the second contact element are mutually interconnected by a overhang (14), the overhang (14) in an assembled state of the lead frame (1) being free from the drain (4).

9. The lead frame (1) according to any one of the preceding claims, wherein the lead frame (1) is made of a material that comprises copper.

10. The lead frame (1) according to any one of the preceding claims, wherein the first (7) and second (8) contact element are mutually spaced apart in an assembled state of the lead frame (1).

11. The lead frame (1) according to any one of the preceding claims, wherein the second contact element (8) comprises a discrete number of individual contact portions (9A, 9B), in particular in between 2 and 10 contact portions (9A, 9B).

12. The lead frame (1) according to any one of the preceding claims, wherein the first contact element (7) comprises at least two contact portions that in an assembled state of the lead frame (1) each contact the source (3) of the semiconductor die (2) with a contact area thereof, the contact areas of the respective contact portions being spaced apart from each other.

13. A semiconductor package (100) comprising a semiconductor die (2) and the lead frame (1) according to any one of the claims 1 - 12, the lead frame (1) being connected to the semiconductor die (2).

14. The semiconductor package (100) according to claim 13, wherein the semiconductor die (2) is a metal-oxide-semiconductor field-effect transistor (MOSFET).
